# EUROPÄISCHE PATENTSCHRIFT

(11) **EP 2 238 276 B1**
(45) Veröffentlichungstag und Bekanntmachung des Hinweises auf die Patenterteilung: **24.09.2014**
(21) Anmeldenummer: 08872208.7
(22) Anmeldetag: 18.12.2008
(51) Int. Cl.: C23C 14/56, C23C 16/54

(54) **SCHLEUSENVORRICHTUNG ZUM EIN- UND AUSBRINGEN VON BEHÄLTERN IN UND AUS EINER VAKUUMBEHANDLUNGSKAMMER**
LOCK DEVICE FOR ADDING AND REMOVING CONTAINERS TO AND FROM A VACUUM TREATMENT CHAMBER
SYSTÈME DE SAS POUR L'ENTRÉE ET LA SORTIE DE RÉCIPIENTS DANS ET HORS D'UNE CHAMBRE DE TRAITEMENT SOUS VIDE

(30) Priorität: 04.02.2008 DE 102008007629
(43) Veröffentlichungstag der Anmeldung: 13.10.2010
(73) Patentinhaber: Krones AG, 93073 Neutraubling (DE)
(72) Erfinder: ALBRECHT, Thomas, 92339 Beilngries (DE)
(74) Vertreter: Grünecker, Kinkeldey, Stockmair & Schwanhäusser
(86) Internationale Anmeldenummer: PCT/EP2008/010848
(87) Internationale Veröffentlichungsnummer: WO 2009/097888

(56) Entgegenhaltungen:
- EP-A- 1 577 419
- EP-B- 0 943 699
- DE-A1- 2 840 949
- FR-A- 2 106 858
- GB-A- 1 565 521
- GB-A- 2 143 910
- JP-A- 58 009 241

## Beschreibung

Die Erfindung betrifft eine Schleusenvorrichtung zum kontinuierlichen Ein- und Ausbringen von Behältern in und aus einer Vakuumbehandlungskammer.

Derartige Schleusenvorrichtungen werden z.B. für vakuumgestützte Beschichtungsprozesse benötigt, um z. B. die Gasdichtigkeit von PET-Flaschen zu erhöhen, die dazu üblicherweise bei einem Unterdruck von etwa 10 bis 40 mbar behandelt werden. Ein kontinuierliches Ein- bzw. Ausschleusen ist dabei für einen wirtschaftlichen Herstellungsprozess unabdingbar.

Eine gattungsgemäße Schleuseneinrichtungen ist z. B. aus der EP 0943699 B1 bekannt. Diese Schleuse umfasst ein Karussellgehäuse mit einem in diesem drehbar gelagerten Schleusenkammerrad, in dem umfangsseitig Schleusenkammern mit Öffnungen zum Be- und Entladen von zu schleusenden Behältern vorgesehen sind.

Das Karussellgehäuse umfasst Saugstutzen zum Evakuieren der Schleusenkammern, die durch umfangsseitige Dichtungen auf dem Schleusenrad von einander atmosphärisch abgedichtet sind. Die Schleusenkammern zwischen der Beschickungsstation bzw. der Entladestation im Außenraum und dem evakuierten Behandlungsraum bilden eine differentielle Druckstufe, wobei der Schleusenkammerdruck umlaufend in Richtung des Behandlungsraums von dem im Außenraum üblicherweise herrschenden atmosphärischen Druck auf den in den Behandlungsraum herrschenden Druck abnimmt.

Aufgrund der aufwändigen Herstellung des Karussellgehäuses und des Schleusenkammerrads ist eine nachträgliche Anpassung der Vorrichtung an unterschiedliche Behältergrößen und -formen jedoch kostspielig oder gar nicht möglich. Um auch für große Behälter ausreichend große Schleusenkammern in einer für die differentielle Druckstufe ausreichenden Zahl bereit stellen zu können, ist es zudem erforderlich, den Durchmesser des Schleusenrads entsprechend zu erhöhen. Dies bedingt eine ggf. unerwünscht breite Bauform.

Die EP 1577419 A beschreibt eine Schleuseneinrichtung gemäß dem Oberbegriff des Anspruchs 1.

Eine weitere, aus der DE 27 47 061 A bekannte Schleuseneinrichtung dient dazu, Bänder in eine bzw. aus einer Vakuumbeschichtungskammer durch eine Druckstufenstrecke ein- bzw. auszuschleusen. Die Schleuseneinrichtung umfasst mehrere hintereinander angeordnete feststehende Schleusenkammern, die mit schlitzförmigen Blenden von einander getrennt sind. Das zu beschichtende Band wird auf einem Trägerband durch die Schlitzblenden und die Schleusenkammern transportiert. Um ein Druckgefälle zwischen den Kammern erzeugen zu können, müssen die Blenden an den Querschnitt des Trägerbandes und des zu beschichtenden Bandes angepasst werden. Eine solche Vorrichtung ist jedoch für das Ein- und Ausschleusen von Behältern nicht praktikabel, da diese im Gegensatz zu einem Band in Laufrichtung gesehen keinen konstanten Querschnitt aufweisen bzw. Lücken zwischen den einzelnen Flaschen unvermeidlich sind.

Der vorliegenden Erfindung liegt die Aufgabe zugrunde, eine gattungsgemäße Schleusenvorrichtung zu schaffen, die ein kontinuierliches Ein- und Ausbringen von Behältern in und aus einem Vakuumbeschichtungsraum in einen Raum mit Atmosphärendruck ermöglicht, die jedoch nicht die vorgenannten nachteiligen Einschränkungen aufweist.

Diese Aufgabe wird mit einer Schleusenvorrichtung mit den Merkmalen des Anspruchs 1 gelöst. Demnach umfasst die Schleuse ein umlaufendes, gerade Transportabschnitte aufweisenden Transportmittel mit an dem Transportmittel im Abstand angeordneten Trägerplatten zum Halten der Behälter, mit wenigstens teilweise entlang der geraden Abschnitte verlaufenden Schleusenkanälen, durch die die Behälter von Transportmitteln transportiert werden, wobei die Trägerplatten so ausgebildet sind, dass sie mit den Kanalwänden eine solche Abdichtwirkung erzielen, dass in den Schleusenkanälen ein Druckgefälle erzeugt werden kann.

Die Schleusenvorrichtung kann durch Austauschen der Trägerplatten und/oder Änderung des Abstands zwischen den Trägerplatten auf flexible und kostengünstige Art an geänderte Anforderungen angepasst werden.

Vorteilhafterweise ist in der Kanalwand eine Absaugöffnung oder eine Belüftungsöffnung ausgebildet. Dadurch lässt sich der Schleusenkanal evakuieren oder belüften, ohne störende Leitungen im Kanal vorsehen zu müssen.

Vorteilhafterweise ist in der Kanalwand eine Absaugöffnung oder eine Belüftungsöffnung ausgebildet. Dadurch lässt sich der Schleusenkanal evakuieren oder belüften, ohne störende Leitungen im Kanal vorsehen zu müssen.

In einer günstigen Ausführungsform sind die Trägerplatten an der der Absaugöffnung oder Belüftungsöffnung zugewandten Seite zumindest abschnittsweise dicker als die lichte Weite der Absaugöffnung oder Belüftungsöffnung, so dass die Öffnung von den Trägerplatten verschlossen werden kann. Damit lässt sich ein Druckausgleich im Schleusenkanal zeitlich steuern.

Vorzugsweise sind in Laufrichtung des Transportmittels weitere, im Abstand angeordnete Absaugöffnungen oder Belüftungsöffnungen ausgebildet. Dies erlaubt eine Absaugung oder Belüftung mit abschnittsweise unterschiedlichem Druck.

Besonders vorteilhaft ist es, im Schleusenkanal zwischen den Vorder- und Rückseiten der Trägerplatten stufenförmige Druckunterschiede erzeugen zu können. Dies ermöglicht es, Bereiche unterschiedlichen Drucks innerhalb des Schleusenkanals mit den Trägerplatten zu verschieben.

Günstigerweise ist der Schleusenkanal als differentielle Druckstufe ausgebildet, in der der Druck in Richtung der Vakuumbehandlungskammer abnimmt. Dadurch können die Flaschen schrittweise an den Unterdruck in der Behandlungskammer angepasst werden.

In einer besonders vorteilhaften Ausführungsform umfassen die Trägerplatten jeweils mindestens eine am Rand umlaufende Dichtung, die an der Kanalwand anliegt. Dadurch lässt sich die abdichtende Wirkung der Trägerplatten verbessern.

Vorteilhaft ist es ferner, das Transportmittel in Form von zwei übereinander angeordneten Ketten, Zahnstangen, Zugstangen oder Riemen auszubilden. Dies ermöglicht eine gleichmäßige Kraftübertragung auf die Trägerplatten und vermeidet, dass sich die Platten im Schleusenkanal neigen.

In einer besonders vorteilhaften Ausführungsform umfassen die Trägerplatten Rollen, die die Platten an der Kanalwand abstützen. Dadurch wird vermieden, dass die Platten kippen oder sich verkanten. Außerdem sorgen die Rollen dafür, dass die Platten über den gesamten Umfang einen im Wesentlichen konstanten Abstand zur Kanalwand einhalten und so eine gleichmäßige Dichtwirkung erzielt wird.

Günstigerweise sind die Trägerplatten mittig an dem Transportmittel befestigt. Dadurch lässt sich ein Moment auf die Abstützrollen vermeiden.

Vorteilhafterweise umfasst die Kanalwand plattenförmige seitliche Segmente, die durch Halbschalen verbunden sind. Dies ermöglicht eine gute Dichtwirkung sowie eine kostengünstige Herstellung und Anpassung an unterschiedliche Flaschengrößen.

Die Erfindung wird nachfolgend anhand eines bevorzugten und in Figuren dargestellten Ausführungsbeispiels näher beschrieben. Es zeigen:
- Fig. 1: eine Draufsicht auf eine erfindungsgemäße Schleusenvorrichtung;
- Fig. 2: eine Schrägansicht der Schleuseneinrichtung aus Fig. 1 mit benachbarter Behandlungskammer;
- Fig. 3: eine Detailansicht der Schleuseneinrichtung aus Fig. 1;
- Fig. 4: eine Schrägansicht einer Trägerplatte mit Kettensegmenten und Flaschen;
- Fig. 5: einen schematischen Schnitt in der Draufsicht durch eine erfindungsgemäße differentielle Druckschleuse.

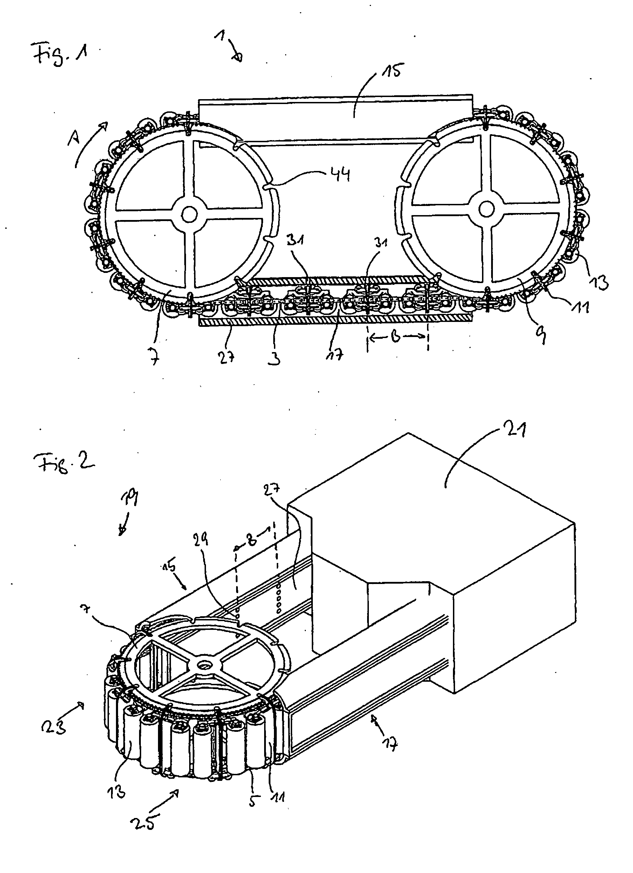

Die in Fig. 1 dargestellte erfindungsgemäße Schleusenvorrichtung umfasst ein Transportmittel in Form von zwei übereinander angeordnete Ketten 3, 5 (in Fig. 1 ist nur die obere Kette 3 dargestellt), die um zwei Kettenräder 7, 9 in Richtung des Pfeils A laufen, und an denen in regelmäßigen Abständen B Trägerplatten 11 zum Halten von zu behandelnden Flaschen 13 in im Wesentlichen orthogonaler Position zur Laufrichtung vorgesehen sind. Die geraden Abschnitte der Ketten 3, 5 verlaufen überwiegend durch Schleusenkanäle 15, 17.

Gemäß Fig. 2 befindet sich das Kettenrad 7 in einem Außenraum 19 unter normalem Atmosphärendruck, während das Kettenrad 9 (in Figur 2 nicht dargestellt) in einer evakuierten Behandlungskammer 21 angeordnet ist. Die Flaschen 13 werden in einem Beschickungsbereich 23 zugeführt und in einem Entladebereich 25 wieder entnommen (Das Beschicken und Entladen ist nicht dargestellt).

In der Wand 27 des Schleusenkanals 15 sind im Abstand B Absaugöffnungen 29 vorgesehen, an die geeignete Pumpen, z. B. Vakuumpumpen (nicht dargestellt) angeschlossen werden, so dass der jeweils anliegende Druck p in Laufrichtung A abnimmt.

Gemäß Fig. 1 sind in der Wand 27 des Schleusenkanals 17 ebenfalls im Abstand B Belüftungsöffnungen 31 vorgesehen. An diese können geeignete Pumpen angeschlossen werden, so dass der jeweils anliegende Druck p in Laufrichtung A zunimmt. Es ist jedoch auch möglich, den Schleusenkanal 17 passiv durch die Belüftungsöffnungen 31 zu belüften, z. B. über geeignet dimensionierte Verbindungen (nicht dargestellt) zum Außenraum 19 oder über einen Kurzschluss zum Einlaufkanal 15, um das Vakuum zu recyceln.

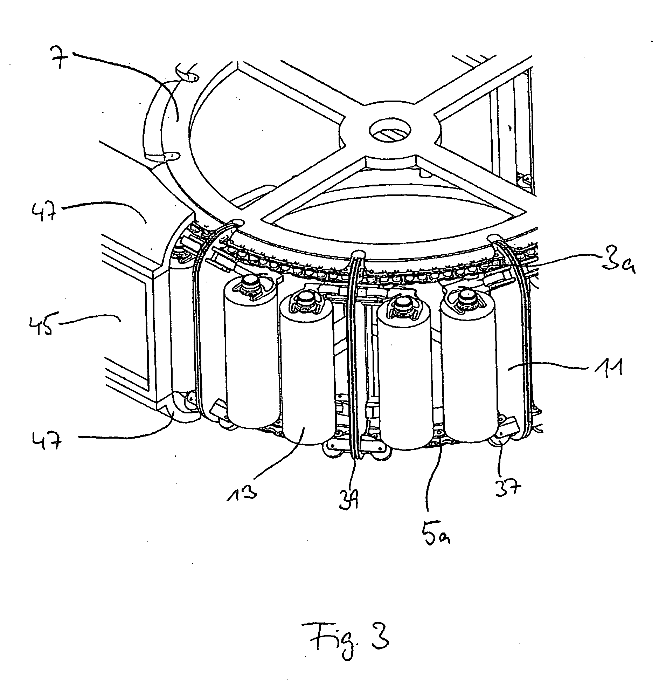

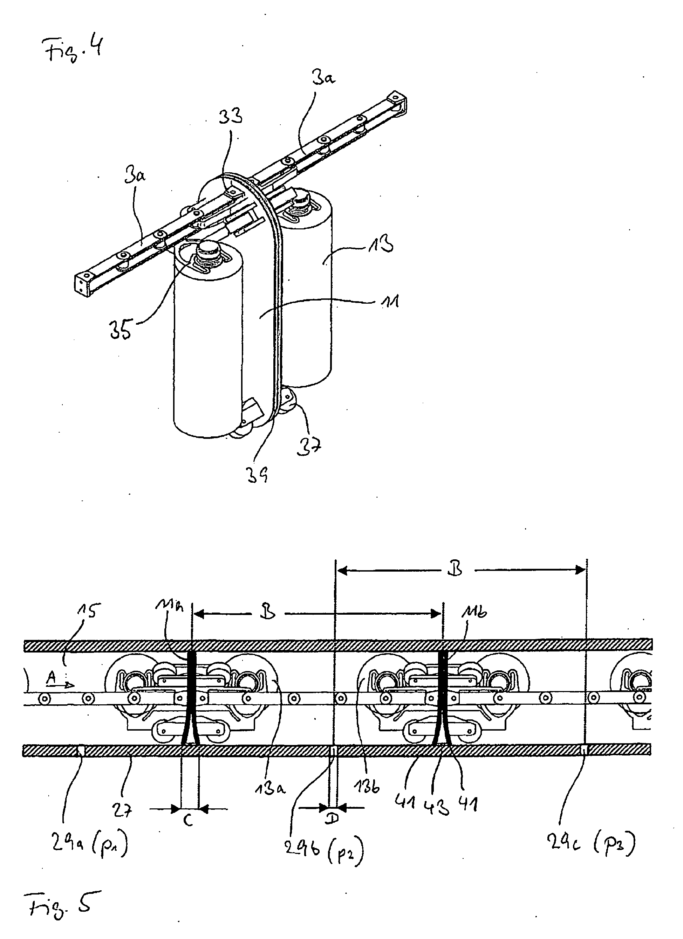

Wie den Fig. 3 und 4 zu entnehmen ist, bestehen die Ketten 3, 5 aus Kettensegmenten 3a, 5a, deren Enden jeweils mittig an den Trägerplatten 11 angebracht sind. Zu diesem Zweck ist an den Vorderseiten (in Laufrichtung A weisend) und Rückseiten der Trägerplatten 11 jeweils ein Kettenanschlussglied 33 vorgesehen.

Jede Trägerplatte 11 umfasst je eine Klammer 35 zum Halten der Flaschen 11 auf der Plattenvorderseite und auf der Plattenrückseite, sowie Rollen 37, die die Trägerplatten an den Wänden 27 der Schleusenkanäle 15, 17 abstützen. Die Trägerplatte 11 weist ferner zwei umlaufende Nuten 39 auf, die, wie in Fig. 5 gezeigt, jeweils eine an der Kanalwand anliegende Dichtung 41 aufnehmen. Der Abstand zwischen den Nuten 41 ist auf der den Absaugöffnungen 29 bzw. Belüftungsöffnungen 31 zugewandten Seite der Trägerplatte 11 vergrößert. Dadurch wird an der Trägerplatte 11 ein abdichtender Bereich 43 bereitgestellt, dessen Länge C (in Laufrichtung A) größer ist als die lichte Weite D der Absaugöffnung 29 bzw. der Belüftungsöffnung 31 (in Fig. 5 sind beispielhaft Absaugöffnungen gezeigt).

Die Kettensegmente 3a, 5a sind bevorzugt als Rollenketten ausgebildet. Damit lassen sich auf einfache Weise Kettensegmente 3a, 5a einheitlicher Länge herstellen und mittels der Kettenanschlussglieder 33 befestigen. Es ist aber ebenso gut möglich, ein erfindungsgemäßes Transportmittel auf Basis von Zahnstangen, Zugstangen oder Riemen auszubilden.

Das Kettenrad 7 ist bevorzugt verschiebbar gelagert. Auf diese Weise lässt sich die Spannung der Ketten 3, 5 einstellen. Am Umfang der Kettenräder 7, 9 sind im Abstand B Nuten 44 vorgesehen, in die die Trägerplatten 11 eingreifen. Die Kettenräder 7, 9 können außerdem in die Glieder der Ketten 3, 5 eingreifen. Werden an Stelle der Ketten 3, 5 Zahnstangen verwendet, so kann deren Antrieb über Zahnräder erfolgen.

Die Schleusenkanäle 15, 17 umfassen jeweils zwei rechteckige Platten 45, die mit zwei Halbschalen 47 mit halbkreisförmigem Querschnitt verschraubt sind. Dies ermöglicht einen flexiblen, modularen Aufbau. Der resultierende Kanalquerschnitt erlaubt außerdem eine gute Abdichtwirkung der Trägerplatten 11. Die Schleusenkanäle 15, 17 könnten jedoch auch einen anderen Querschnitt aufweisen und/oder aus einer unterschiedlichen Zahl von Einzelteilen zusammengesetzt bzw. aus einem Stück gefertigt sein. Die Schleusenkanäle 15, 17 sind bevorzugt aus Metall, insbesondere aus härtbarem Stahl gefertigt.

Die Absaugöffnungen 29 des Schleusenkanals 17 sind bevorzugt als Bohrungen ausgebildet, können jedoch auch einen anderen, z. B. rechteckigen Querschnitt aufweisen. In Fig. 2 sind je fünf Absaugöffnungen 29 übereinander angeordnet. Es ist jedoch auch eine davon abweichende Anzahl möglich. Entscheidend ist, dass alle Absaugöffnungen 29 von dem abdichtenden Bereich 43 der Trägerplatte 11 gleichzeitig verschlossen werden können. Dies gilt ebenso für die Belüftungsöffnungen 31 des Schleusenkanals 19, d.h. die Absaugöffnungen 29 und die Belüftungsöffnungen 31 sind so angeordnet und geformt, dass diese gleichzeitig von den Trägerplatten 11 überfahren und dabei verschlossen werden.

In Fig. 2 sind in Laufrichtung A zwei Gruppen von je fünf Absaugöffnungen 29 dargestellt. Wie in der Funktionsbeschreibung ausführlich erläutert, entsprechen diese Gruppen zwei differentiellen Druckstufen, ebenso wie die in Fig. 1 gezeigten beiden Belüftungsöffnungen 31. Die Anzahl der differentiellen Druckstufen kann jedoch davon abweichen, wie z. B. in Fig. 5 gezeigt. Ebenso kann sich die Anzahl der saugseitigen und der belüftungsseitigen Druckstufen unterscheiden.

Bei der in den Figuren dargestellten Ausführungsform basieren die Druckstufen auf der Absaugung bzw. Belüftung durch die Öffnungen 29, 31 in der Kanalwand 27. Alternativ ist es jedoch auch denkbar, die Öffnungen 29, 31 durch eine interne Absaugung bzw. Belüftung in den Schleusenkanälen 15, 17 zu ersetzen, z. B. durch geeignete Leitungen in den Schleusenkanälen 15, 17 und/oder in der Kanalwand 27.

Die Trägerplatten 11 sind bevorzugt aus Metall, wie z. B. Edelstahl oder Aluminium, oder aus Kunststoff gefertigt, und ihre Form ist an den Querschnitt der Schleusenkanäle 15, 17 so angepasst, dass eine gleichmäßige Dichtwirkung durch die Dichtungen 41 oder einen Dichtspalt (nicht dargestellt) erzielt wird.

Die Dichtungen 41 sind als Lippendichtungen ausgebildet. Die Zahl der Dichtungen kann jedoch von der gezeigten Ausführungsform nach oben oder unten abweichen. Alternativ könnten auch andere Abdichtmittel verwendet werden oder die Trägerplatten 11 so präzise an den Querschnitt der Schleusenkanäle 15, 17 angepasst werden, dass eine ausreichende Abdichtwirkung, einschließlich des abdichtenden Bereichs 43, auch ohne die Dichtungen 41 z. B. mit einem Dichtspalt erzielt wird.

Die Trägerplatten 11 werden in den Schleusenkanälen 15, 17 durch die Rollen 37 abgestützt, so dass die Platten 11 nicht kippen oder sich verkanten können und die Platten 11 über den gesamten Umfang einen im Wesentlichen gleichmäßigen Abstand zur Kanalwand 27 einhalten, um auf diese Weise eine gleichmäßige Dichtwirkung z.B. mit einem gleichmäßigen Dichtspalt zu erzielen. Die dargestellte Anzahl und Position der Rollen 37 ist beispielhaft und richtet sich u. a. nach der Lage der Absaugöffnungen 29. Außerhalb der Schleusenkanäle 15, 17 müssen die Trägerplatten 11 nicht an den Rollen 37 geführt werden.

Die Kettenanschlussglieder 33 sind mittig auf den Trägerplatten 11 angeordnet. Somit greifen die Ketten 3, 5 oben und unten mittig an der Trägerplatte 11 an, um ein Moment auf die Abstützrollen 37 zu vermeiden. Bei Verwendung anderer Antriebsmittel, wie z. B. Zahnstangen, Zugstangen oder Riemen, sind die Anschlussglieder 33 jeweils dazu passend ausgebildet.

Die Klammern 35 sind so angeordnet, dass die Flaschen 13 zwischen der oberen Kette 3 und der unteren Kette 5 gehalten werden.

Nachfolgend wir die Funktionsweise der im Ausführungsbeispiel gezeigten Schleusenvorrichtung anhand der in Fig. 5 gezeigten benachbarten Flaschen 13a, 13 b erläutert. Hierbei ist unter "benachbarten" Flaschen zu verstehen, dass diese im Schleusenkanal im Wesentlichen dem selben Druck ausgesetzt sind und von "nicht benachbarten" Flaschen mit den Trägerplatten 11a, 11 b durch ein Druckgefälle getrennt sind.

Die Ketten 3, 5 werden kontinuierlich angetrieben, z.B. durch einen auf das Kettenrad 7 wirkenden Motor (nicht dargestellt). An den Absaugöffnungen 29a, 29b, 29c liegt jeweils kontinuierlich ein Unterdruck p₁, p₂, p₃ an, wobei p₁ > p₂ > p₃.

Die zu behandelnden Flaschen 13a, 13b werden mit einer geeigneten Beschickungsstation (z. B. einem üblichen Sternrad) im Bereich 23 an die Klammern 35 der Trägerplatten 11a, 11 b übergeben und in den eingangsseitigen Schleusenkanal 15 verbracht. Dort stehen die Flaschen 13a, 13b zunächst unter normalem Atmosphärendruck. Sobald die vordere Platte 11 b die erste Absaugöffnung 29a passiert, steht der Bereich zwischen den Platten 11a und 11b mit der Absaugöffnung 29a in Verbindung und wird bei gleichzeitig fortgesetztem Kettentransport bis maximal zum Absaugdruck p₁ evakuiert. Dieser Evakuierungsschritt dauert so lange, bis die hintere Platte 11a über die erste Absaugöffnungen 29a fährt und diese dadurch verschließt. Da die Trägerplatten 11 und die Absaugöffnungen 29 im Wesentlichen im jeweils gleichen Abstand B zueinander angeordnet sind, fährt die vordere Platte 11 b gleichzeitig über die zweite Absaugöffnung 29b.

Sobald nun die vordere Platte 11 b die zweite Absaugöffnung 29b passiert, steht der Bereich zwischen den Platten 11 a und 11 b mit der Absaugöffnung 29b in Verbindung und wird solange bis maximal zum Absaugdruck p₂ evakuiert, bis die hintere Platte 11a über die zweite Absaugöffnungen 29b fährt und diese dadurch verschließt. Somit wurde der Bereich zwischen den Platten 11a und 11 b bis zu diesem Zeitpunkt in zwei Stufen evakuiert und damit eine differentielle Druckstufe realisiert.

Dieses Vorgehen lässt sich durch Überfahren weiterer Absaugöffnungen 29 mit niedrigerem Druck, z.B. der in Fig. 5 gezeigten dritten Absaugöffnung 29c, wiederholen, bis der Druck in dem Bereich zwischen den Platten 11 a und 11 b auf das gewünschte Druckniveau, z.B. das der Behandlungskammer 21, gesenkt ist.

Anschließend laufen die Flaschen in die Vakuumkammer 21 ein, werden dort behandelt (z. B. unter Erzeugung eines Plasmas beschichtet) und gelangen dann in den ausgangsseitigen Schleusenkanal 17 . Dort wird der Druck zwischen den Platten 11a und 11 b schrittweise durch Überfahren der Belüftungsöffnungen 31 wieder angehoben. Das Vorgehen ist dabei analog zur oben beschriebenen schrittweisen Evakuierung, jedoch mit umgekehrten Vorzeichen.

Im Gegensatz zur bekannten Karussellschleuse kommt die erfindungsgemäße Schleuse ohne kostspielige Komponenten aus, wie z.B. einen aufwändig herzustellenden Kammerrotor oder das Rotorgehäuse. Stattdessen können mit der Erfindung unterschiedliche differenzielle Druckstufen mit im Wesentlichen einheitlichen bzw. standardisierten Komponenten, wie z. B. den Trägerplatten 11, realisiert und bei Bedarf modifiziert werden.

## Patentansprüche

1. Schleusenvorrichtung (1) zum kontinuierlichen Ein- und Ausbringen von Behältern (13) in und aus einer Vakuumbehandlungskammer (21),
mit einem umlaufenden, gerade Transportabschnitte aufweisenden Transportmittel (3, 5);
**gekennzeichnet durch**
- an dem Transportmittel im Abstand (B) angeordneten Trägerplatten (11) zum Halten der Behälter;
- wenigstens teilweise entlang der geraden Abschnitte verlaufenden Schleusenkanäle (15, 17), **durch** die die Behälter von dem Transportmittel transportiert werden,
- wobei die Trägerplatten so ausgebildet sind, dass sie mit den Kanalwänden eine solche Abdichtwirkung erzielen, dass in den Schleusenkanälen ein Druckgefälle erzeugt werden kann.

2. Schleusenvorrichtung nach Anspruch 1, **dadurch gekennzeichnet, dass** in der Kanalwand (27) eine Absaugöffnung (29) oder eine Belüftungsöffnung (31) ausgebildet ist.

3. Schleusenvorrichtung nach Anspruch 2, **dadurch gekennzeichnet, dass** die Trägerplatten (11) an der der Absaugöffnung (29) oder Belüftungsöffnung (31) zugewandten Seite zumindest abschnittsweise dicker sind als die lichte Weite (D) der Absaugöffnung oder Belüftungsöffnung, so dass die Öffnung von den Trägerplatten beim Vorbeitransport zeitweise verschlossen wird.

4. Schleusenvorrichtung nach Anspruch 2 oder 3, **dadurch gekennzeichnet, dass** in Laufrichtung des Transportmittels weitere, im Abstand (B) angeordnete Absaugöffnungen (29) oder Belüftungsöffnungen (31) ausgebildet sind.

5. Schleusenvorrichtung nach einem der vorigen Ansprüche, **dadurch gekennzeichnet, dass** in den Schleusenkanälen (15, 17) zwischen den Vorder- und Rückseiten der Trägerplatten (11) stufenförmige Druckunterschiede erzeugt werden können.

6. Schleusenvorrichtung nach einem der vorigen Ansprüche, **dadurch gekennzeichnet, dass** die Schleusenkanäle (15, 17) als differentielle Druckstufen ausgebildet sind, in denen der Druck in Richtung der Vakuumbehandlungskammer (21) abnimmt.

7. Schleusenvorrichtung nach einem der vorigen Ansprüche, **dadurch gekennzeichnet, dass** die Trägerplatten (11) jeweils mindestens eine umlaufende Dichtung (41) umfassen, die an der Kanalwand (27) anliegt.

8. Schleusenvorrichtung nach einem der vorigen Ansprüche, **dadurch gekennzeichnet, dass** das Transportmittel (3, 5) in Form von zwei übereinander angeordneten Ketten, Zahnstangen, Zugstangen oder Riemen ausgebildet ist.

9. Schleusenvorrichtung nach einem der vorigen Ansprüche, **dadurch gekennzeichnet, dass** die Trägerplatten (11) Rollen (37) umfassen, die die Trägerplatten an der Kanalwand (27) abstützen.

10. Schleusenvorrichtung nach einem der vorigen Ansprüche, **dadurch gekennzeichnet, dass** die Trägerplatten (11) mittig an dem Transportmittel (3, 5) befestigt sind.

11. Schleusenvorrichtung nach einem der vorigen Ansprüche, **dadurch gekennzeichnet, dass** die Kanalwand (27) plattenförmige seitliche Segmente (45) umfassen, die durch Halbschalen (47) verbunden sind.

## Claims

1. Lock device (1) for continuously adding and removing containers (13) to and from a vacuum treatment chamber (21), with a revolving transport means (3, 5) comprising straight transport sections,
**characterized by**
carrier plates (11) arranged at the transport means at a distance (B) for holding the containers;
lock channels (15, 17) at least partially extending along the straight sections through which the containers are transported by the transport means,
wherein the carrier plates are embodied such that they achieve such a sealing effect with the channel walls that a drop of pressure can be generated in the lock channels.

2. Lock device according to claim 1, **characterized in that** a suction opening (29) or a ventilation opening (31) is embodied in the channel wall (27).

3. Lock device according to claim 2, **characterized in that** the carrier plates (11) are at least in sections thicker at the side facing the suction opening (29) or the ventilation opening (31) than the clearance (D) of the suction opening or ventilation opening, so that the opening is temporarily closed by the carrier plates while they are transported past it.

4. Lock device according to claim 2 or 3, **characterized in that** further suction openings (29) or ventilation openings (31) arranged at a distance (B) are embodied in the moving direction of the transport means.

5. Lock device according to one of the preceding claims, **characterized in that** stepwise pressure differences can be generated in the lock channels (15, 17) between the front and rear sides of the carrier plates (11).

6. Lock device according to one of the preceding claims, **characterized in that** the lock channels (15, 17) are embodied as differential pressure stages in which the pressure is reduced towards the vacuum treatment chamber (21).

7. Lock device according to one of the preceding claims, **characterized in that** the carrier plates (11) each comprise at least one surrounding seal (41) which lies against the channel wall (27).

8. Lock device according to one of the preceding claims, **characterized in that** the transport means (3, 5) is embodied in the form of two chains, toothed racks, tension bars or belts arranged one upon the other.

9. Lock device according to one of the preceding claims, **characterized in that** the carrier plates (11) comprise rollers (37) which support the carrier plates at the channel wall (27).

10. Lock device according to one of the preceding claims, **characterized in that** the carrier plates (11) are centrically fixed to the transport means (3, 5).

11. Lock device according to one of the preceding claims, **characterized in that** the channel wall (27) comprises plate-like lateral segments (45) which are connected by half bowls (47).

## Revendications

1. Dispositif de sas (1) pour assurer en continu l'entrée et la sortie de contenants ou récipients (13) dans ou respectivement d'une chambre de traitement sous vide (21),
comprenant un moyen de transport (3, 5) en circulation sans fin, qui présente des tronçons de transport rectilignes ;
**caractérisé par**
- des plaques de support (11) destinées à supporter les contenants et agencées sur le moyen de transport selon une distance d'espacement (B) ;
- des canaux de sas (15, 17), qui s'étendent au moins partiellement le long des tronçons rectilignes, et à travers lesquels les contenants sont transportés par le moyen de transport,
- les plaques de support étant conçues de manière à ce qu'elles réalisent un effet d'étanchéité tel avec les parois de canal, qu'il soit possible de produire une chute de pression dans les canaux de sas.

2. Dispositif de sas selon la revendication 1, **caractérisé en ce que** dans la paroi de canal (27) est formée une ouverture d'aspiration (29) ou une ouverture de ventilation (31).

3. Dispositif de sas selon la revendication 2, **caractérisé en ce que** les plaques de support (11), sur leur côté dirigé vers l'ouverture d'aspiration (29) ou l'ouverture de ventilation (31), sont, au moins par secteurs, plus épaisses que la largeur interne (D) de l'ouverture d'aspiration ou de l'ouverture de ventilation, de sorte que l'ouverture est fermée temporairement par les plaques de support lors du passage pour le transport.

4. Dispositif de sas selon la revendication 2 ou la revendication 3, **caractérisé en ce que** dans la direction d'avancement du moyen de transport, sont réalisées d'autres ouvertures d'aspiration (29) ou ouvertures de ventilation (31) agencées selon la distance d'espacement (B).

5. Dispositif de sas selon l'une des revendications précédentes, **caractérisé en ce qu'**il est possible de produire dans les canaux de sas (15, 17), des différences de pression étagées entre les côtés avant et arrière des plaques de support (11).

6. Dispositif de sas selon l'une des revendications précédentes, **caractérisé en ce que** les canaux de sas (15, 17) sont réalisés en tant qu'étages de pression différentielle, dans lesquels la pression diminue en direction de la chambre de traitement sous vide (21).

7. Dispositif de sas selon l'une des revendications précédentes, **caractérisé en ce que** les plaques de support (11) comprennent chacune au moins un joint d'étanchéité (41) périphérique, qui s'appuie contre la paroi de canal (27).

8. Dispositif de sas selon l'une des revendications précédentes, **caractérisé en ce que** le moyen de transport (3, 5) est réalisé sous la forme de deux chaines, crémaillères, tirants de traction ou courroies, respectivement superposés.

9. Dispositif de sas selon l'une des revendications précédentes, **caractérisé en ce que** les plaques de support (11) comportent des galets (37) assurant l'appui des plaques de support contre la paroi de canal (27).

10. Dispositif de sas selon l'une des revendications précédentes, **caractérisé en ce que** les plaques de support (11) sont fixées en leur centre au moyen de transport (3, 5).

11. Dispositif de sas selon l'une des revendications précédentes, **caractérisé en ce que** la paroi de canal (27) comprend des segments latéraux (45) en forme de plaque, qui sont reliés par des demi-coques (47).
